## Europäisches Patentamt

## European Patent Office

## Office européen des brevets

(11) Veröffentlichungsnummer: **0 196 473**
**B1**

(12) **EUROPÄISCHE PATENTSCHRIFT**

(45) Veröffentlichungstag der Patentschrift:
**07.12.88**

(51) Int. Cl.⁴: **H 01 L 39/14**

(21) Anmeldenummer: **86102728.2**

(22) Anmeldetag: **03.03.86**

(54) Hochfeld-Supraleiter mit einer Armierung sowie Verfahren zur Herstellung und Verwendung diese Supraleiters.

(30) Priorität: **15.03.85 DE 3509422**

(43) Veröffentlichungstag der Anmeldung:
**08.10.86 Patentblatt 86/41**

(45) Bekanntmachung des Hinweises auf die Patenterteilung:
**07.12.88 Patentblatt 88/49**

(84) Benannte Vertragsstaaten:
**DE FR GB**

(56) Entgegenhaltungen:
**FR-A- 2 119 205**
**FR-A- 2 502 832**
**GB-A- 1 160 566**
**US-A- 3 395 000**

(73) Patentinhaber: **Siemens Aktiengesellschaft Berlin und München, Wittelsbacherplatz 2, D-8000 München 2 (DE)**

(72) Erfinder: **Wohlleben, Karl, Dr., Dipl.-Phys., Markweg 15, D-8520 Erlangen (DE)**

## Beschreibung

Die Erfindung bezieht sich auf einen Hochfeld-Supraleiter, der in eine Matrix aus normalleitendem Material eingebettete supraleitende Leiteradern aufweist und mit einer Armierung aus einer mechanisch festen, nicht-magnetischen NiMo-Legierung versehen ist. Ein derartiger Hochfeld-Supraleiter geht aus DE-C-2 759 640 hervor. Die Erfindung betrifft ferner ein Verfahren zur Herstellung sowie eine Verwendung dieses Supraleiters.

Hochfeld-Supraleiter, die im Betriebsfalle Magnetfeldern mit magnetischen Flussdichten über 5 Tesla (T) ausgesetzt werden können, benötigen bei grossen Magnetdurchmessern im allgemeinen eine zusätzliche mechanische Armierung aus hochfestem Material, um z. B. auftretende Lorentzkräfte aufnehmen zu können. Dies trifft insbesondere bei Supraleitern vom Typ $A_3B$ mit spröden intermetallischen Phasen mit A15-Kristallstruktur ihres supraleitenden Materials zu. Diese Leiter lassen sich bevorzugt nach dem sogenannten Bronze-Prozess herstellen (vgl. z. B. «IEEE Transactions on Magnetics», Vol. MAG-17, No. 1, Jan. 1981, Seiten 646 bis 653). So beträgt bei nach diesem Prozess hergestellten $Nb_3Sn$-Vielkernleitern die Bruchdehnung nur etwa 1%; eine Degradation des kritischen Stromes $I_c$ tritt aber schon bei einer Dehnung $\varepsilon$ um 0,6% auf, wobei dieser Wert unter anderem vom Bronzeanteil im Leiter und vom Durchmesser seiner einzelnen supraleitenden Filamente abhängt.

Für eine Armierung solcher Hochfeld-Supraleiter bestehen insbesondere die folgenden beiden Möglichkeiten bzw. Leiterkonzepte:

### Konzept 1

Bei Supraleitern mit einer A15-Phase ist bereits während der zur Bildung dieser Phase erforderlichen Reaktionsglühung, die z. B. bei $Nb_3Sn$-Vielkernleitern bei etwa 700 °C durchgeführt wird, eine Armierung im Leiter integriert. Hierzu sind zwei Möglichkeiten gegeben, nämlich

a) einen monolithischen Verbund der Armierung mit dem Supraleiter auszubilden (vgl. z. B. «IEEE Trans. Magn.», Vol. MAG-19, No. 3, Mai 1983, Seiten 1441 bis 1444) oder

b) die Armierung als hochfesten Mantel um einen lose verkabelten Leiter, wie er insbesondere für eine forcierte Kühlung zu verwenden ist, vorzusehen (vgl. z. B. «Cryogenics», Juli 1980, Seiten 373 bis 389).

### Konzept 2

Die Armierung kann aber auch nachträglich dem bereits reagierten Supraleiter hinzugefügt werden. Hierzu kann man die Armierung

a) an die Aussenseite z. B. durch Löten, Schweissen, Kleben o. ä. anbringen, oder

b) der Supraleiter und das Armierungsmaterial werden durch einen Verformungsprozess, wie z. B. durch Strangpressen oder durch Walzen, miteinander innig verbunden.

An die gemäss den vorstehend genannten Konzepten auszubildenden Armierungen sind eine Reihe von Forderungen zu stellen:

A) Die thermische Kontraktion der Armierung bei Abkühlen von der Reaktionstemperatur (Konzept 1) oder von Löt- bzw. Strangpresstemperaturen (Konzept 2) auf die Betriebstemperatur von etwa 4 K soll möglichst gut an die thermische Kontraktion des zu armierenden Supraleiters mit A15-Phase angepasst sein. Ein durch Bronze-Prozess gefertigter unstabilisierter, d. h. keinen Anteil an z. B. Cu als Stabilisierungsmaterial aufweisender $Nb_3Sn$-Leiter zeigt nämlich beim Abkühlen von z. B. 700 °C Reaktionstemperatur auf 4 K eine Längenkontraktion von integral etwa 1,1%. Da die $Nb_3Sn$-Phase weniger kontrahiert als Bronze, steht sie folglich im nicht-armierten Supraleiter unter innerer Druckspannung, die bei 4 K zu einer Vorkompression des $Nb_3Sn$ von ca. 0,3% führt, wobei dieser Wert unter anderem vom Bronze-Anteil im Leiter und vom Filamentdurchmesser abhängt. Durch die Vorkompression nimmt $I_c$ von $Nb_3Sn$ gegenüber dem spannungsfreien Zustand ab. Durch Hinzufügen einer Armierung kann man jedoch die Vorkompression und damit $I_c$ des Leiters ändern: Bei grösserer thermischer Kontraktion der Armierung kommt $Nb_3Sn$ unter zusätzliche Druckspannung, wodurch $I_c$ weiter abnimmt. Hingegen erhöht sich bei kleinerer Kontraktion der Armierung zwar zunächst $I_c$ bis zu einem spannungsfreien Zustand des $Nb_3Sn$ mit maximalem $I_c$; gleichzeitig verliert jedoch der Supraleiter von seiner an sich schon kleinen Toleranz an Biege- und Zugdehnung; d. h. Dehnungen des armierten Leiters, z. B. durch Lorentzkräfte, führen dann eher zu einer $I_c$-Abnahme nach Durchschreiten des spannungsfreien Zustandes von $Nb_3Sn$ als bei einer Armierung mit angepasster thermischer Kontraktion.

B) Die Armierung soll hohe mechanische Festigkeit besitzen, d. h. möglichst grosse Werte für den E-Modul und die Streckgrenze $\delta_{02}$ und ausreichende Bruchdehnung $\varepsilon_B$, insbesondere bei tiefer Temperatur von 4 K aufweisen. Dadurch kann der Querschnittsanteil der Armierung im Leiter möglichst niedrig bleiben, so dass die letztlich entscheidende Stromdichte in einer Magnetwicklung entsprechend erhöht wird.

C) Im Hinblick auf eine Integration der Armierung in den Supraleiter ist ausserdem zu fordern: Ist die Armierung bereits während der Reaktionsglühung in dem Leiter integriert (Konzept 1), so dürfen sich die Festigkeitswerte der Armierung durch diese Temperaturbehandlung nicht wesentlich verschlechtern. Soll die Armierung nachträglich dem bereits reagierten Leiter hinzugefügt werden, muss sie lötbar (Konzept 2a) oder z. B. mit Aluminium verpressbar (Konzept 2b) sein.

D) Um keine störenden magnetischen Eigenfelder zu erzeugen, soll die Armierung möglichst nicht-(ferro)magnetisch sein. Diese Forderung kann gegebenenfalls entfallen, wenn die Magnetwicklung nur mit Gleichstrom und bis zur Sättigung einer ferromagnetischen Armierung betrieben wird.

E) Die Armierung soll in für den jeweiligen Leiteraufbau geeigneter Dimension lieferbar sein.

Mit bekannten Armierungen sind jedoch alle die genannten Forderungen kaum zu erfüllen. So ist z. B. in dem Bericht der «Applied Superconductivity Conference», San Diego – USA, 9. bis 13. September 1984, Paper CM 7, ein $Nb_3Sn$-Monolithleiter mit integrierter zentraler Stahlarmierung vorgestellt, der infolge hoher thermischer Kontraktion des Stahls eine kaum akzeptable hohe Ic-Degradation aufweist. Durch Verwendung eines Verbundes aus Molybdän und Stahl gelingt es dabei zwar, die thermische Kontraktion auf den gewünschten Wert einzustellen; dieser Verbund verliert jedoch bei 4 K fast vollständig seine Plastizität, so dass die Bruchdehnung $\varepsilon_B$ bei nur etwa 0,32% liegt.

Aus dem weiteren Papier DL 11 der vorgenannten Conference ist ein forciert gekühlter, verkabelter Supraleiter (Konzept 1b) bekannt, der mit einer speziellen FeNiCu-Legierung mit dem Handelsnamen «Incoloy 903» (eingetragenes Warenzeichen der Firma INCO Ltd., Toronto – Kanada) armiert ist. Das genannte Armierungsmaterial ist jedoch ferromagnetisch.

Ferner ist aus der Veröffentlichung «Filamentary A15 Superconductors», Plenum Press 1980, New York, Seiten 233 bis 240 ein vorreagierter $Nb_3Sn$-Supraleiter bekannt, auf den eine Armierung aus Kupfer mit eingebetteten Wolframdrähten aufgelötet ist. Der armierte Supraleiter zeigt zwar den erwarteten höheren E-Modul; jedoch bleibt dieser Effekt verhältnismässig gering, da Wolfram nur zu einem beschränkten Volumenanteil von < 10% im Leiter enthalten ist.

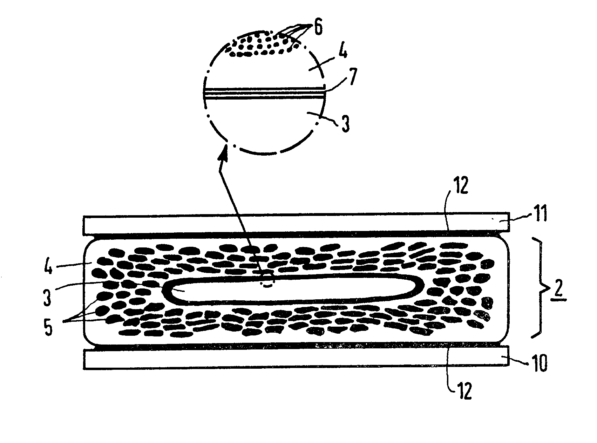

Darüber hinaus ist es auch bekannt, vorreagierte $Nb_3Sn$-Supraleiter mit halbhartem Kupfer zur Armierung und gleichzeitigen elektrischen Stabilisierung zu verlöten (vgl. z. B. «IEEE Trans. Magn.», Vol. MAG-17, No. 1, Jan. 1981, Seiten 1006 bis 1009, insbes. Fig. 5). Eine derartige Armierung bewirkt jedoch eine deutliche $I_c$-Degradation z. B. um etwa 30% bei 10 Tesla infolge der hohen thermischen Kontraktion des Kupfers (vgl. z. B. «Proceedings of the International Cryogenic Materials Conference», Kobe, Japan, 11.–14.5.1982, Seiten 183 bis 186 oder 215 bis 218).

Auch mit der aus der eingangs genannten DE-C-Schrift bekannten Armierung können die genannten Forderungen nur zum Teil erfüllt werden. Aus dieser Veröffentlichung ist ein Supraleiter des Typs $A_3B$ mit A15-Kristallstruktur bekannt, bei dem eine Anpassung des Ausdehnungskoeffizienten seiner Matrix aus normalleitendem Material an den Ausdehnungskoeffizienten der supraleitenden Verbindung dadurch vorgenommen wird, dass die Matrix mit einer Armierung aus einem vorbestimmten Material versehen wird. Als Matrixmaterial ist eine spezielle NiMo-Legierung vorgeschlagen, die unter dem Handelsnamen «Hastelloy B» (Warenzeichen der Firma Cabot Corp., Boston – USA) bekannt ist. Die Zusammensetzung dieser Legierung (jeweils in Gewichtsprozenten) ist etwa folgendermassen: 30% Mo, 62% Ni, 7% Fe, <0,8% Mn, <1,25% Co, <0,6% Cr, <0,7% Si und <0,1% C. Ihr thermischer Ausdehnungskoeffizient bei 0 °C liegt etwa bei $(10\pm2)\cdot10^{-6}$ $K^{-1}$. Es

sind jedoch keinerlei Einzelheiten bekannt, ob dieses Material lötbar (Konzept 2a) oder mit Aluminium verpressbar (Konzept 2b) ist. Wird dieses Material bereits in einen noch zu glühenden Leiter integriert (Konzept 1), so ist eine deutliche Abnahme der Festigkeitswerte bei dieser Glühbehandlung zu beobachten.

Ausserdem wird das genannte Material in für die grosstechnische Herstellung von Supraleitern geeigneten Dimensionen nicht gefertigt.

Aufgabe der vorliegenden Erfindung ist es deshalb, ein Armierungsmaterial anzugeben, mit dem die genannten Forderungen zumindest weitgehend erfüllt werden können.

Diese Aufgabe wird für einen Supraleiter der eingangs genannten Art mit den im Hauptanspruch angegebenen Merkmale gelöst.

Überraschenderweise wurde festgestellt, dass sich mit den erfindungsgemässen Änderungen der Anteile an Fe, Si und C in der bekannten NiMo-Legierung die genannten Forderungen zumindest weitgehend erfüllen lassen. Die Vorteile des erfindungsgemässen Armierungsmaterials sind demnach insbesondere darin zu sehen, dass dieses nicht-magnetische, kommerziell gefertigte Material bei gut angepasster thermischer Kontraktion eine hohe mechanische Festigkeit (E-Modul, $\sigma_{02}$ aufweist, die sich zudem noch durch eine 700 °C-Glühung erhöht. So lässt sich eine ausreichende Bruchdehnung von etwa 40% im ungeglühten und von etwa 2,5% im geglühten Zustand, jeweils bei 4 K, messen. Darüber hinaus ist dieses Material ohne besonders aufwendige Zusatzmassnahmen direkt lötbar.

Besonders vorteilhaft kann ein erfindungsgemässer Hochfeld-Supraleiter, dessen Leitervorprodukt einer Reaktionsglühung zur Ausbildung des supraleitenden Materials der Leiteradern unterzogen wird, dadurch hergestellt werden, dass das Leitervorprodukt zur Reaktionsglühung auf einen trommelartigen Trägerekörper aufgewickelt wird, der zumindest teilweise aus dem Armierungsmaterial des Supraleiters besteht.

Ferner ist es von besonderem Vorteil, wenn ein erfindungsgemässer Hochfeld-Supraleiter zur Herstellung einer supraleitenden Magnetwicklung verwendet wird, wobei als Wickelkörper der Magnetwicklung ein Bauteil vorgesehen wird, das zumindest teilweise aus dem Armierungsmaterial des Supraleiters besteht.

Weitere vorteilhafte Ausgestaltungen des erfindungsgemässen Supraleiters gehen aus den übrigen Unteransprüchen hervor.

Zur weiteren Erläuterung der Erfindung wird nachfolgend auf die Zeichnung Bezug genommen, in deren Figur eine erfindungsgemässe Ausführungsform eines Hochfeld-Supraleiters veranschaulicht ist.

Die Figur zeigt schematisch den Querschnitt durch einen supraleitenden Rechteckleiter 2, der einen zentralen Kern 3 aus einem Stabilisierungsmaterial, wie z. B. Cu, aufweist. Um diesen Kern 3 ist eine Matrix 4 mit rechteckigem Querschnitt angeordnet. In dieser Matrix befindet sich eine grosse Anzahl von zu Bündeln 5 zusammengefassten Leiteradern bzw. Filamenten 6 aus supraleitendem Material. Bei diesem supraleitenden Material des Rechteckleiters 2 soll es sich insbesondere um ein Material vom Typ $A_3B$ mit einer A15-Kristallstruktur wie z. B. $Nb_3Sn$ handeln. Entsprechende Leiter werden vorteilhaft in einem sogenannten Bronze-Prozess hergestellt. Dementsprechend wird für den in der Figur im supraleitfähigen Endzustand veranschaulichten Leiter 2 zunächst ein Leitervorprodukt mit einer rechteckigen Bronzematrix aufgebaut, in welcher zu Bündeln zusammengefasste Nb-Filamente eingebettet sind. Im Zentrum dieser Matrix befindet sich der als elektrische Stabilisierung dienende Cu-Kern 3. Da bei der für die Ausbildung der supraleitenden $A_3B$-Verbindung erforderlichen Glühbehandlung ein Eindiffundieren von Sn in den Cu-Kern 3 vermieden werden soll, ist dieser vorteilhaft mit einer Diffusionsbarriere 7, z. B. mit mehrfach gewickelten Ta-Folien, umgeben. Nach der Glühbehandlung hat sich zumindest der grösste Teil des Querschnitts der Filamente 6 mit dem Sn der Matrix zu der gewünschten supraleitenden Verbindung umgesetzt. Das Material der Matrix 4 ist dementsprechend an Sn verarmt.

Auf diesen bereits reagierten monolithischen $Nb_3Sn$-Leiter 2 sind dann entsprechend dem Konzept 2a auf gegenüberliegenden Flachseiten der Matrix elektrolytisch verkupferte Bänder oder Streifen 10 und 11 aus dem erfindungsgemässen Armierungsmaterial aufgebracht. Dieses Material soll die folgende Zusammensetzung aufweisen: Zwischen 65 und 75 Gew.-% Ni; zwischen 24 und 32 Gew.-% Mo; jeweils unter 1,5 Gew.-% Mn, Co, Cr; höchstens 2,5 Gew.-% Fe; höchstens 0,1 Gew.-% Si und höchstens 0,02 Gew.-% C.

Vorzugsweise wird eine NiMo-Legierung als Armierungsmaterial vorgesehen, die die folgende Zusammensetzung hat: Zwischen 26 und 30 Gew.-% Mo, höchstens 2 Gew.-% Fe; jeweils höchstens 1 Gew.-% Cr, Co und Mn; höchstens 0,08 Gew.-% Si, höchstens 0,03 Gew.-% P, höchstens 0,015 Gew.-% S, höchstens 0,01 Gew.-% C, Rest Ni. Eine derartige Legierung wird unter dem Handelsnamen «Hastelloy B2» (eingetragenes Warenzeichen der Firma Cabot Corp., Boston, USA) angeboten.

Die aus diesem Material hergestellten Streifen 10 und 11 sind ohne weiteres auf die äusseren Flachseiten der Matrix auflötbar, wobei in der Figur die entsprechenden Lötschichten mit 12 bezeichnet sind. Zum Löten können dabei z. B. reines In, reines Sn oder spezielle SnPb-Legierungen verwendet werden. Gegebenenfalls kann auch auf eine besondere Verkupferung der Streifen 10 und 11 aus dem genannten Material verzichtet werden, falls deren Oberfläche z. B. durch Ätzen oder Schmirgeln vorbehandelt wird.

Gemäss einem konkreten Ausführungsbeispiel des Rechteckleiters 2 weist dieser bei Abmessungen seines Querschnittes von 1,0 mm × 4 mm 127 Bündel zu je 84 supraleitenden $Nb_3Sn$-Filamenten auf. Der zentrale Cu-Kern 3 mit der ihn umgebenden Diffusionsbarriere 7 aus dreifach gewickelter Ta-Folie nimmt dabei einen Querschnittsanteil von etwa 20% ein. Auf diesen Leiter wurden nun auf nur einer oder auf beiden Breitseiten 0,2 mm dicke und 4 mm breite Streifen bzw. Bänder aus dem vorbestimmten Armierungsmaterial aufgelötet. Bei einer einseitigen Armierung betrug somit der Flächenanteil q der Armierung am gesamten Leiterquerschnitt etwa 17%, bei beidseitiger Armierung etwa 29%. Verlötet wurde auf den gestreckten Supraleiter 2 in einem heizbaren Presswerkzeug. Die Streifen 10 und 11 wurden im unbehandelten Zustand sowie nach einer Vakuumglühung von 64 Stunden bei 700 °C untersucht, um so deren Eignung auch für den Fall, dass die Armierung bei der Reaktionsglühung bereits im Supraleiter integriert ist (Konzept 1) nachzuweisen. Spannungs-Dehnungsmessungen an solchen Armierungsstreifen bzw. -bändern mit einem jeweiligen Querschnitt von 0,2 mm × 4 mm ergaben hohe Festigkeitswerte bei Raum- bzw. Tieftemperatur:

| | Raumtemperatur (300 K) | | | |
| | $\sigma_{02}$ [MPa] | $\sigma_{max}$ [MPa] | $\varepsilon_B$ [%] | E-Modul [GPa] |
|---|---|---|---|---|
| unbehandelt | 560 | 1150 | 50 | 175 |
| nach 64 h/ 700 °C/Vakuum | 900 | 1230 | 4 | 173 |

| | Tieftemperatur (4 K) | | | |
| | $\sigma_{02}$ [MPa] | $\sigma_{max}$ [MPa] | $\varepsilon_B$ [%] | E-Modul [GPa] |
|---|---|---|---|---|
| unbehandelt | 894 | 1406 | 39 | |
| nach 64h/ 700 °C/Vakuum | 1066 | 1475 | 2,5 | 133 |

Die unbehandelten Streifen waren bei etwa 1100 °C lösungsgeglüht worden. Die nachträgliche 700 °C-Glühung bewirkt eine Härtung durch Ausscheiden Mo-reicher Phasen.

$I_c$-Messungen bei magnetischen Flussdichten B von 10 Tesla bis 12 Tesla an entsprechenden $Nb_3Sn$-Leitern ohne Armierung und mit einseitig oder beidseitig aufgelöteten Armierungsstreifen ergaben:

α) Auflöten der erfindungsgemässen Armierung erhöht stets $I_c$; und zwar im Mittel um etwa 12% bei einseitiger Armierung mit einem Armierungsanteil q von etwa 17% und um 20% bei beidseitiger Armierung mit q von etwa 29%. Der $Nb_3Sn$-Vielkernleiter 2 kontrahiert also beim Abkühlen von Löttemperatur auf 4 K etwas stärker als das Armierungsmaterial, so dass die Vorkompression des $Nb_3Sn$ im Leiter durch diese Armierung etwas abgebaut wird.

β) Ablöten des Armierungsmaterials ergibt praktisch wieder $I_{co}$ des nicht-armierten Leiters. Der Supraleiter erfährt also keine bleibende Dehnung. Die Verformungen innerhalb des Verbunds aus Supraleiter 2 und Armierungsstreifen 10 und 11 beim Abkühlen von Löttemperatur auf 4 K verlaufen noch vollständig im elastischen Bereich.

γ) Ungeglühtes und 700 °C-geglühtes Armierungsmaterial ergeben praktisch identische $I_c$-Erhöhungen. Dies ist darauf zurückzuführen, dass man voll im Elastizitätsbereich bleibt und der E-Modul im Gegensatz zu $\sigma_{02}$ durch die 700 °C-Glühung kaum geändert wird.

Es lässt sich somit feststellen, dass die erfindungsgemässe Armierung sowohl während der zur Bildung von A15-Phasen erforderlichen Reaktionsglühungen im Supraleiter integriert sein kann (Konzept 1), als auch nachträglich dem bereits reagierten Supraleiter hinzugefügt werden kann (Konzept 2). Wegen der etwas kleineren thermischen Kontraktion eignet sich das gewählte Armierungsmaterial besonders zur Armierung von Nb₃Sn-Leitern. Dabei steht dem Vorteil einer $I_c$-Erhöhung zwar eine Reduktion der erlaubten Dehnung gegenüber; aber die verbleibende Dehnungsreserve ist für den praktischen Einsatz noch voll ausreichend. Ausserdem lässt sich die Dehnungsreserve eines in einer Magnetwicklung gebogenen Supraleiters noch vergrössern oder verkleinern, wobei stets eine Abnahme bzw. Zunahme von $I_c$ verbunden ist, indem man die neutrale Achse im gebogenen Leiter aus der Symmetrieebene, d.h. dessen Mittelebene verschiebt. Dies kann z. B. leicht erreicht werden, indem man Innen- und Aussenseite des gebogenen Leiters unterschiedlich stark, d.h. unterschiedlich dick armiert.

Aufgrund der geringeren thermischen Kontraktion und hohen Festigkeit des gewählten Armierungsmaterials ist dieses vorteilhaft auch für einen trommelartigen Trägerkörper geeignet, auf welchen das Leitervorprodukt des zu erstellenden Nb₃Sn-Supraleiters zum Zweck seiner Reaktionsglühung aufgewickelt wird. Auf einem entsprechenden bekannten Körper aus z. B. VA-Stahl sitzt nämlich der Supraleiter nach der Glühung verhältnismässig locker, woraus sich Gefahren für den spröden Supraleiter beim Abwickeln ergeben.

Ausserdem kann vorteilhaft das gewählte Armierungsmaterial auch für den Wickelkörper einer Spule selbst zum Aufwickeln von A15-Supraleitern, und zwar zur Herstellung von Magnetwicklungen sowohl nach der sogenannten Wind-andreact- als auch nach der React-and-wind-Methode dienen (vgl. z. B. DE-A-2 907 083).

Dem Ausführungsbeispiel nach der Figur wurde ein Hochfeld-Nb₃Sn-Supraleiter zugrundegelegt, der gemäss dem Konzept 2a armiert ist. Selbstverständlich ist die erfindungsgemässe Armierung ebensogut auch für die ferner genannten Konzepte geeignet. Ausserdem muss es sich bei dem supraleitenden Material nicht unbedingt um einen nach der Bronzetechnik hergestellten A15-Supraleiter wie z. B. mit Nb₃Sn- oder V₃Ga-Filamenten handeln. Vielmehr ist die erfindungsgemässe Armierung auch für Leitertypen aus anderen intermetallischen supraleitenden Verbindungen oder aus anderen Legierungen wie z. B. NbTi geeignet. Dabei braucht die Stabilisierung nicht nur, wie in dem Ausführungsbeispiel dargestellt, einen zentralen Kern aus einem Stabilisierungsmaterial wie z. B. Cu oder Al umfassen. Vielmehr sind alle bekannten Stabilisierungsarten geeignet.

## Patentansprüche

1. Hochfeld-Supraleiter, der in eine Matrix (4) aus normalleitendem Material eingebettete supraleitende Leiteradern (6) aufweist und mit einer Armierung (10, 11) aus einer mechanisch festen, nicht-magnetischen NiMo-Legierung versehen ist, welche zwischen 65 und 75 Gew.-% Ni, zwischen 24 und 32 Gew.-% Mo und jeweils unter 1,5 Gew.-% Mn, Co, Cr enthält und welche einen thermischen Ausdehnungskoeffizienten bei 0 °C zwischen $8 \cdot 10^{-6}$ K$^{-1}$ und $12 \cdot 10^{-6}$ K$^{-1}$ hat, wobei der Gehalt des Armierungsmaterials an Fe höchstens 2,5 Gew.-%, an Si höchstens 0,1 Gew.-% und an C höchstens 0,02 Gew.-% beträgt.

2. Hochfeld-Supraleiter nach Anspruch 1, dadurch gekennzeichnet, dass der Gehalt des Armierungsmaterials an Mo zwischen 26 und 30 Gew.-% liegt sowie an Fe höchstens 2 Gew.-%, an Mn, Co, Cr jeweils höchstens 1 Gew.-% und an Si höchstens 0,08 Gew.-% beträgt.

3. Hochfeld-Supraleiter nach Anspruch 1 oder 2, dadurch gekennzeichnet, dass das Armierungsmaterial höchstens 0,03 Gew.-% P, höchstens 0,015 Gew.-% S und höchstens 0,01 Gew.-% C enthält.

4. Hochfeld-Supraleiter nach einem der Ansprüche 1 bis 3, dadurch gekennzeichnet, dass als Armierung Teile (Streifen 10, 11) vorgesehen sind, die einer Glühbehandlung unterzogen worden sind.

5. Hochfeld-Supraleiter nach einem der Ansprüche 1 bis 4, dadurch gekennzeichnet, dass das supraleitende Material seiner Leiteradern (Filamente 6) aus einer nach der Bronze-Technik erstellten intermetallischen Verbindung besteht.

6. Hochfeld-Supraleiter nach einem der Ansprüche 1 bis 5, dadurch gekennzeichnet, dass seine Armierung auf seiner Aussenseite aufgebracht oder in die Matrix integriert ist.

7. Hochfeld-Supraleiter nach Anspruch 6, dadurch gekennzeichnet, dass seine Matrix (4) etwa rechteckige Gestalt aufweist und die Armierung in Form eines oder mehrerer Streifen (10, 11) auf einer bzw. mehreren Flachseiten der Matrix (4) aufgelötet ist.

8. Hochfeld-Supraleiter nach Anspruch 7, dadurch gekennzeichnet, dass auf den gegenüberliegenden Flachseiten der Matrix (4) Armierungs-Streifen (10, 11) mit unterschiedlicher Stärke (Dicke) aufgelötet sind.

9. Hochfeld-Supraleiter nach Anspruch 7 oder 8, dadurch gekennzeichnet, dass das Lot (12) aus In, Sn oder einer PbSn-Legierung besteht.

10. Verfahren zur Herstellung eines Hochfeld-Supraleiters, dessen Leitervorprodukt einer Reaktionsglühung zur Ausbildung des supraleitenden Materials der Leiteradern unterzogen wird, nach einem der Ansprüche 1 bis 9, dadurch gekennzeichnet, dass das Leitervorprodukt zur Reaktionsglühung auf einen trommelartigen Trägerkörper aufgewickelt wird, der zumindest teilweise aus dem Armierungsmaterial des Supraleiters besteht.

11. Verwendung des Hochfeld-Supraleiters nach einem der Ansprüche 1 bis 9 zur Herstellung einer supraleitenden Magnetwicklung mit der Massgabe, dass als Wickelkörper der Magnetwicklung ein Bauteil vorgesehen wird, das zumindest teilweise aus dem Armierungsmaterial des Supraleiters besteht.

## Claims

1. High field superconductor, which has superconducting conductor wires (6) bedded into a matrix (4) of normal-conducting material, and equipped with an armouring (10, 11) of a mechanically rigid, non-magnetic NiMo-alloy, which contains between 65 and 75% by weight Ni, between 24 and 32% by weight Mo and in each case below 1.5% by weight Mn, Co, Cr and which has a thermal expansion coefficient at 0 °C between $8 \cdot 10^{-6} K^{-1}$ and $12 \cdot 10^{-6} K^{-1}$, whereby the armouring material contains at the most 2.5% by weight of Fe, at the most 0.1% by weight of Si and at the most 0.02% by weight of C.

2. High field superconductor according to claim 1, characterised in that the armouring material has a content which lies at between 26 and 30% by weight of Mo and also at the most 2% by weight of Fe, at the most at 1% by weight of, in each case, Mn, Co, Cr, and 0.08% by weight at the most of Si.

3. High field superconductor according to claim 1 or 2, characterised in that the armouring material contains at the most 0.03% by weight of P, at the most 0.015% by weight of S and at the most 0.01% by weight of C.

4. High field superconductor according to one of claims 1 to 3, characterised in that parts (strips 10, 11) are provided as armouring, which have undergone an annealing treatment.

5. High field superconductor according to one of claims 1 to 4, characterised in that the super conducting material of the conducting wires (filaments 6) consist of an intermetallic compound prepared by the bronze-technique.

6. High field superconductor according to one of claims 1 to 5, characterised in that the armouring thereof is fixed on its outer side or integral with the matrix.

7. High field superconductor according to claim 6, characterised in that its matrix (4) has an approximately rectangular form and the armouring, in the form of one or several strips (10, 11), is soldered onto one or several flat sides of the matrix (4).

8. High field superconductor according to claim 7, characterised in that armouring strips (10, 11) with differing strength (thickness) are soldered onto the opposing flat sides of the matrix (4).

9. High field superconductor according to claim 7 or 8, characterised in that the solder (12) consists of In, Sn or a PbSn alloy.

10. Method of manufacturing a high-field superconductor, the conducting preproduct of which undergoes a reaction of annealing for formation of the superconducting material of the conducting wires, according to one of claims 1 to 9, characterised in that the conducting preproduct for reaction of annealing is wound on a drum like carrier body, which consists at least partially of the armouring material of the conducting material.

11. Application of the high-field superconductor according to one of claims 1 to 9 for manufacturing a superconducting magnet winding provided that as winding body of the magnet winding a component is provided which consists at least partially of the armouring material of the superconductor.

## Revendications

1. Supraconducteur à champ d'intensité élevée, qui comporte des fils supraconducteurs (6) noyés dans une matrice (4) formée d'un matériau normalement conducteur et est muni d'une armature (10, 11) formée par un alliage de NiMo amagnétique et solide du point de vue mécanique, contenant entre 65 et 75% en poids de Ni, entre 24 et 32% en poids de Mo et respectivement moins de 1,5% en poids de Mn, Co, Cr et possédant un coefficient de dilatation thermique à 0 °C, compris entre $8 \cdot 10^{-6} K^{-1}$ et $12 \cdot 10^{-6} K^{-1}$, la teneur du matériau de l'armature en Fe étant égale au maximum à 2,5% en poids, sa teneur en Si étant égale au maximum à 0,1% en poids et sa teneur en C étant égale au maximum à 0,02% en poids.

2. Supraconducteur à champ d'intensité élevée suivant la revendication 1, caractérisé par le fait que la teneur du matériau de l'armature en Mo est comprise entre 26 et 30% en poids, que sa teneur en Fe est égale au maximum à 2% en poids, que sa teneur en Mn, Co, Cr est égale respectivement au maximum à 1% en poids et que sa teneur en Si est égale au maximum à 0,08% en poids.

3. Supraconducteur à champ d'intensité élevée suivant la revendication 1 ou 2, caractérisé par le fait que le matériau de l'armature contient au maximum 0,03% en poids de P, au maximum 0,015% en poids de S et au maximum 0,01% en poids de C.

4. Supraconducteur à champ d'intensité élevée suivant l'une des revendications 1 à 3, caractérisé par le fait qu'on utilise, comme armature, des éléments (bandes 10, 11), qui ont été soumis à un traitement de recuit.

5. Supraconducteur à champ d'intensité élevée suivant l'une des revendications 1 à 4, caractérisé par le fait que le matériau supraconducteur de ses fils conducteurs (filaments 6) est constitué par un composé intermétallique, formé selon la technique du bronze.

6. Supraconducteur à champ d'intensité élevée suivant l'une des revendications 1 à 5, caractérisé par le fait que son armature est disposée sur sa face extérieure ou est intrégrée dans la matrice.

7. Supraconducteur à champ d'intensité élevée suivant la revendication 6, caractérisé par le fait que sa matrice (4) possède une forme approximativement rectangulaire et que l'armature réalisée sous la forme d'une ou de plusieurs bandes (10, 11) est fixée par brasage sur un ou plusieurs côtés plats de la matrice (4).

8. Supraconducteur à champ d'intensité élevée suivant la revendication 7, caractérisé par le fait que des bandes d'armature (10, 11) possédant des calibres (épaisseurs) différents, sont fixés par brasage sur les côtés plats opposés de la matrice (4).

9. Supraconducteur à champ d'intensité élevée suivant la revendication 7 ou 8, caractérisé par le fait que le métal d'apport de brasage (12) est constitué par du In, du Sn ou par un alliage de PbSn.

10. Procédé pour fabriquer un supraconducteur à champ d'intensité élevée, dont l'ébauche des conducteurs est soumise à un recuit réactionnel de manière à former le matériau supraconducteur des fils conducteurs, suivant l'une des revendications 1 à 9, caractérisé par le fait que pour le recuit réactionnel, on enroule l'ébauche des conducteurs sur un corps de support en forme de tambour, qui est constitué au moins partiellement par le matériau de l'armature du supraconducteur.

11. Application du supraconducteur à champ d'intensité élevée suivant l'une des revendications 1 à 9 pour la fabrication d'un enroulement magnétique supraconducteur, moyennant la condition selon laquelle on prévoit, en tant que corps de bobinage de l'enroulement magnétique, un composant constitué au moins en partie par le matériau de l'armature du supraconducteur.